# EUROPÄISCHE PATENTSCHRIFT

(11) **EP 2 737 333 B1**
(45) Veröffentlichungstag und Bekanntmachung des Hinweises auf die Patenterteilung: **14.06.2017**
(21) Anmeldenummer: 12740178.4
(22) Anmeldetag: 27.07.2012
(51) Int. Cl.: G01S 7/282, G01S 13/02, H03B 28/00, G01S 13/28, G01S 7/03, H04L 27/00, H03K 5/1534, G01S 7/288

(54) **VERFAHREN ZUM BETREIBEN EINER UWB-EINRICHTUNG**
ULTRA WIDE BAND RADAR WITHOUT LOCAL OSCILLATOR
RADAR À BANDE ULTRA LARGE SANS OSCILLATEUR LOCAL

(30) Priorität: 28.07.2011 EP 11175705; 28.07.2011 US 201161512493 P
(43) Veröffentlichungstag der Anmeldung: 04.06.2014
(73) Patentinhaber: Elmos Semiconductor Aktiengesellschaft, 44227 Dortmund (DE)
(72) Erfinder: SUNTKEN, Artur, Wilhelm, 0056 Tiegerpoort (ZA)
(74) Vertreter: dompatent von Kreisler Selting Werner - Partnerschaft von Patent- und Rechtsanwälten mbB
(86) Internationale Anmeldenummer: PCT/EP2012/064795
(87) Internationale Veröffentlichungsnummer: WO 2013/014272

(56) Entgegenhaltungen:
- WO-A1-01/93441
- WO-A2-01/28310
- WO-A2-01/93482
- US-A1- 2004 174 928
- US-B1- 6 330 274

## Beschreibung

### Einleitung

Die Erfindung betrifft ein Verfahren zum Betreiben einer UWB-(Ultra-Wide-Band-)Einrichtung als Radar oder zu Kommunikationszwecken.

### Stand der Technik

Es existieren Radar-Systeme, die auf der Aussendung einzelner Pulse und einer Pulsformung beruhen. Auch ist es durchaus üblich, für die Modulation und Demodulation z.B. analoge Multiplizierer zu verwenden.

Aus WO-A-01/93441 ist eine UWB-Sende- bzw. Empfangseinheit für UWB Spread-Spectrum für die Kommunikation bekannt. Bei dieser bekannten Einrichtung werden logische "Einsen" und logische "Nullen" erzeugt, die durch jeweils einer Folge mehrerer Pulse mit alternierendem Vorzeichen bzw. mit alternierender Polarität erzeugt werden, wobei die Reihenfolge, in der die Pulse aufeinanderfolgen, verschieden ist, um eine logische Eins gegenüber einer logischen Null unterscheiden zu können. Hierbei wird mit Verstärkerschaltungen und Summierern gearbeitet, was vergleichsweise aufwendig ist.

Aus US-A-2004/0174928 ist ein Verfahren und eine Vorrichtung zum Senden und Empfangen von Spread Spectrum Signalen kontinuierlichen Wellenformen bekannt. Die Signale werden dabei durch einzelne Pulse, die unterschiedlich stark gewichtet sind, erzeugt.

Ein ähnliches Verfahren und eine ähnliche Vorrichtung gemäß US-A-2004/0174928 sind aus WO-A-01/93482 bekannt.

WO-A-01/28310 zeigt einen adaptiven Hochfrequenz-Transceiver.

Aus US-B-6/330,274 ist ein Spread-Spectrum-Correlator mit Gilbert-Multiplizieren bekannt.

### Aufgabe der Erfindung

Eine Aufgabe der Erfindung ist es, eine Ansteuerung für eine Ultra Wide Band (UWB)-Einrichtung mit einer niederenergetischen (insbesondere für Anwendungen mit autarker Energieversorgung) und dennoch aber einfachen und zuverlässigen Sendesignalerzeugung und/oder Empfangssignalverarbeitung zu schaffen.

### Erfindung

Zur Lösung dieser Aufgabe wird mit der Erfindung ein Verfahren zum Betreiben einer mindestens eine Sendeantenne und/oder mindestens eine Empfangsantenne aufweisenden UWB-Einrichtung vorgeschlagen, wobei das Verfahren die Schritte des Anspruchs 1 aufweist; einzelne Ausgestaltungen der Erfindung sind Gegenstand der Unteransprüche.

Erfindungsgemäß wird der Sendepuls der UWB-Einrichtung durch eine Kombination von Einzelpulsen unterschiedlicher Polarität und unterschiedlicher Amplitude erzeugt. Hierzu dienen Stromquellen, die in Form von Widerständen realisiert sind. Die Besonderheit der Erfindung besteht darin, dass die unterschiedlich großen Widerstände, mit denen Pulse unterschiedlicher Höhe erzeugt werden können, durch Parallelschaltung einer den Gesamtwiderstandswert des betreffenden Widerstandes ergebenden Anzahl von elektronischen Schaltern (Schalttransistoren) realisiert werden.

Durch das erfindungsgemäße Konzept der Sendepulsgenerierung durch zeitlich gesteuert erzeugte Einzelpulse benötigt die erfindungsgemäße UWB-Einrichtung lediglich geringe Energie, was insbesondere für autark arbeitende Anwendungen von Vorteil ist. Die erfindungsgemäße UWB-Einrichtung lässt sich dabei sowohl als UWB-Radar als auch als UWB-Kommunikationseinrichtung nutzen. Während das UWB-Radar zur Detektion von Körpern, Gegenständen o.dgl. innerhalb eines Erfassungsbereichs dient, bezweckt die UWB-Kommunikationseinrichtung die Kommunikation durch Aussenden von (modulierten) Sendepulsen durch eine Sendeantenne, die dann von einer Empfangsantenne empfangen werden.

In vorteilhafter Weiterbildung der Erfindung ist vorgesehen, dass die Ansteuerzeitintervalle zweier zeitlich aufeinanderfolgend angesteuerter erster Schaltereinheiten einander überlappen oder zeitlich beabstandet sind.

Zur Verbesserung der Detektionseigenschaften der UWB-Einrichtung in ihrer Anwendung als UWB-Radar ist es zweckmäßig, wenn das Pulssignal zwei um 90° phasenverschobene, im Wesentlichen gleiche Folgen von im Wesentlichen gleichen sinusförmigen Pulsen aufweist.

Zum Zwecke der Korrelation eines von der Empfangsantenne empfangenen Empfangssignals mit dem Sendesignal wird ein Korrelationssignal erzeugt, und zwar genauso wie das Sendesignal und mittels den ersten Schaltereinheiten gleichender zweiter Schaltereinheiten, die sequenziell genauso wie die ersten Schaltereinheiten gemäß dem Zeitschema angesteuert werden.

Ferner kann es zweckmäßig sein, dass die Empfangsantenne mit mindestens einem Gilbert-Multiplizierer mit jeweils einer Differenzstufe aus einem Paar von Transistoren verbunden ist, wobei mit der Differenzstufe des Gilbert-Multiplizierers ein- und ausschaltbare zweite Schaltereinheiten verbunden sind, über die dem Gilbert-Multiplizierer ein zum Ansteuerpulssignal für die Sendeantenne im Wesentlichen gleiches Pulssignal zugeführt wird, wobei jede zweite Schaltereinheit eine vorgebbare, insbesondere gleiche, Anzahl an zweiten Schalttransistoren mit jeweils im Wesentlichen gleichen Einschaltwiderstandswerten aufweist, wobei der Widerstand einer zweiten Schaltereinheit entweder durch Verwendung lediglich eines der zweiten Schalttransistoren oder durch Verwendung mehrere zweiter Schalttransistoren, die parallel geschaltet werden, eingestellt wird und wobei die zweiten Schaltereinheiten gemäß im Wesentlichen dem gleichen Zeitschema wie die ersten Schaltereinheiten sequenziell und für das Ansteuerzeitintervall vorbestimmter Länge angesteuert werden.

Vorzugsweise ist die Empfangsantenne mit einem zweiten Gilbert-Multiplizierer gekoppelt, wobei dem einen der beiden Gilbert-Multiplizierer ein mit dem Ansteuerpulssignal für die Sendeantenne im Wesentlichen gleiches Pulssignal und dem anderen der beiden Gilbert-Multiplizierern das zu diesem Pulssignal um 90° phasenverschobene Pulssignal zugeführt wird.

In weiterer vorteilhafter Ausgestaltung der Erfindung ist vorgesehen, dass sämtliche Schalttransistoren jeweils einen Einschalt-Widerstandswert aufweisen, wobei die Abweichung der Einschalt-Widerstandswerte von einem vorgegebenen Referenzwert maximal 10 %, vorzugsweise maximal 5 % beträgt. Die Herstellung derartiger Schalttransistoren vom gleichen Typ kann dadurch realisiert werden, dass die Schalttransistoren
- in einer einzigen Halbleitervorrichtung
   oder
- in unterschiedlichen, jedoch auf einem einzigen Wafer hergestellten Halbleitervorrichtungen
   oder
- in unterschiedlichen Halbleitervorrichtungen auf unterschiedlichen, jedoch in einer gemeinsamen Charge hergestellten Wafer ausgebildet sind.

Verallgemeinert betrifft die Erfindung also ein Verfahren zur drahtlosen Übertragung eines Signals über einen Übertragungskanal zwischen einem Sender und einem Empfänger, insbesondere bei Anordnung eines reflektiven oder transmissiven Objekts zwischen dem Sender und dem Empfänger, unter Anwendung eines Spread-Spectrum-Modulations- und -Demodulationsverfahrens mit Spreizcode-Signalen, vorgeschlagen, bei dem das Spreizcode-Signal durch Addition einer Anzahl n von zeitlich aufeinanderfolgenden, bezüglich ihrer Amplituden gewichteten Pulsen mit Pulsbreite T und unterschiedlichen Vorzeichen erzeugt wird, wobei die Pulse jeweils um einen rationalen Teil i/k, mit i und k jeweils ganzzahlig, der Pulsbreite T zueinander verzögert sind. Der so erzeugte Sendepuls bzw. das so erzeugte Spreizcode-Signal hat insbesondere die Form eines Gaußschen Pulses 5-ter Ordnung. Ein derartiger Sendepuls ist sehr robust und verändert seine Form auch bei mehrfacher Reflektion kaum. Daher eignet sich ein derartiger Sendepuls insbesondere bei der Anwendung der erfindungsgemäßen UWB-Einrichtung als Radar.

Ferner ist es zweckmäßig, wenn die Form der Pulse bezüglich der Breite und der Amplitude veränderbar ist. Diese Pulse weisen im Wesentlichen die Form von sinushalbwellenförmigen Signalen auf, die gewichtet sowie zeitlich verzögert sind und unterschiedliche Vorzeichen aufweisen. Die Ableitung der Pulsdauer erfolgt dabei zweckmäßigerweise ohne Oszillator.

In weiterer vorteilhafter Ausgestaltung der Erfindung ist vorgesehen, dass die Pulse in einem Schaltungsnetzwerk aus parallel zueinander geschalteten Reihenschaltungen mit jeweils einem Schalter und einem gewichteten Widerstand und/oder einer gewichteten Stromquelle gewichtet werden. Desweiteren ist es vorteilhaft, wenn das Spreizcode-Signal sowohl senderseitig als Sendesignal als auch empfängerseitig für eine Korrelation mit dem empfangenen Signal verwendet wird. Hierbei kann ferner mit Vorteil für die sendeseitige und die empfängerseitige Erzeugung des Spreizcode-Signals dieselbe Schaltung oder gleiche Schaltungen verwendet werden.

In weiterer vorteilhafter Ausgestaltung des erfindungsgemäßen Verfahrens ist vorgesehen, dass empfangsseitig mindestens ein Gilbert-Multiplizierer mit mindestens einem analogen und mindestens einem digitalen Eingang oder ein Gilbert-Multiplizierer, bei dem mindestens ein Paar von Differenzstufentransistoren mit mindestens einem gewichteten, steuerbaren Widerstand oder gewichteten, steuerbaren Stromquellen verbunden ist, oder mindestens ein Gilbert-Multiplizierer verwendet wird, bei dem das Spreizcode-Signal unter Verwendung eines Schaltnetzwerks erzeugt wird, das parallel zueinander geschaltete Reihenschaltungen mit jeweils einem Schalter und einem gewichteten Widerstand und/oder einer gewichteten Stromquelle aufweist.
Zweckmäßig ist es, wenn die Pulse in Burst-Gruppen mit jeweils n Pulsen, mit n>1 und n ganzzahlig, gesendet werden und wenn jeder Puls innerhalb einer solchen Burst-Gruppe auf einen anderen Puls dieser Burst-Gruppe durch eine zeitliche Verschiebung um einen Faktor m*T/n, mit T der Pulsdauer und m<(n+1) sowie ganzzahlig, und durch eine Amplitudenmultiplikation mit einer rationalen Zahl a abgebildet wird. Hierbei ist beispielsweise n geradzahlig und größer oder gleich 4, wobei zur Erzeugung des Spreizcode-Signals auf jeden positiven Puls ein negativer Puls und umgekehrt folgt und für jedes Paar aus positiven und negativen Pulsen je ein Multiplizierer vorgesehen ist.

Beispielsweise wird mindestens einer der oder mehrere der oder sämtliche zur Erzeugung des Spreizcode-Signals verwendeten Pulse aus der Detektion des Durchgangs eines Basissignals durch eine Schaltschwelle gewonnen. Hierbei kann als Schaltschwelle eine steigende oder eine fallende Flanke eines digitalen Steuersignals ausgewählt und die betreffende Flanke des Steuersignals durch Flankendetektion ermittelt werden.

Bei einer weiteren vorteilhaften Ausgestaltung der Erfindung werden weitere zur Erzeugung des Spreizcode-Signals verwendete Pulse aus mindestens einem ersten Puls durch Verzögerung dieses ersten Pulses um einen rationalen Bruchteil I/j, mit I und j jeweils ganzzahlig, der Pulsbreite T dieses Pulses erzeugt.

Mit der Erfindung lässt sich einerseits ein UWB-Transmitter im Frequenzbereich von 3 GHz bis 5 GHz, unter Erfüllung der Vorschriften für die spektrale Leistungsdichte sowie bei einer niedrigen Stromaufnahme in Standard-Digital-Technologie implementieren und andererseits ein UWB-Receiver mit niedriger Stromaufnahme bei Auswertung von Echo-Signalen weit unterhalb des Hintergrundrauschens in Standard-Digital-Technologie implementieren.

Für die erfindungsgemäße Transmit-Signal-Erzeugung gilt:
- Signal-Erzeugung für den Transmit-Burst mit Hilfe einer Delay-Line und gewichteten Schaltern.
- Dadurch wird eine sehr gute Annäherung an die ideale Signalform erreicht (Frequenzspektrum).
- Das Konzept verursacht Stromverbrauch nur während der Impulsdauer.
- Es existieren keine Ein- und Ausschwing-Vorgänge.
- Es werden keine Sonder-Bauelemente wie z.B. Spulen verwendet.

Für den Empfang und die Demodulation gilt ferner erfindungsgemäß:
- Template-Erzeugung für den Gilbert-Multiplizierer mit Hilfe einer Delay-Line und gewichteten Schaltern.
- Es kommt nur eine Delay-Line zum Einsatz, welche den Transmit-Signalgenerator sowie die Template-Generatoren im Empfänger ansteuert.
- Die Schalter an sich sind Bestandteil des Multiplizierers - der Umweg über ein analoges Template-Signal wird vermieden. Der entwickelte Gilbert-Multiplizierer ist im Prinzip ein Multiplizierer, der das analoge Signal von der Antenne mit einem digitalen Signal (gewichtete Schalter) multipliziert.
- Es wird nur Versorgungsleistung während der Burst-Dauer benötigt.
- Das demodulierte Signal (DC-Mittelwert) wird über eine Sample-Schaltung und einen Integrator für den DA-Wandler aufbereitet, der relativ langsam sein darf.
- Durch die Verwendung von zwei Demodulierern (Multiplizierern) und zwei Templates (0 und 90 Grad) lässt sich stets der Betrag des reflektierten Signals ermitteln und dadurch ein "Scannen" in Schritten von < 80 psec vermeiden, was ein Vielfaches an Zeitaufwand bei der Bewegungserkennung bedeutet.

Die Erfindung wird nachfolgend anhand zweier Ausführungsbeispiele und unter Bezugnahme auf die Zeichnung näher erläutert. Im Einzelnen zeigen dabei:
- Fig. 1: ein Blockschaltbild eines beispielhaften Systems,
- Fig. 2: ein beispielhaftes Wavelet-Template aus mehreren gewichteten Pulsen,
- Fig. 3: den Sende-Generator als Netzwerk aus zeitlich verringert zu betätigenden, gewichteten Schaltern,
- Fig. 4: eine Steuerpulsgeneratorstufe,
- Fig. 5: einen Gilbert-Multiplizierer,
- Fig. 6: eine schaltbare gewichtete Stromquelle,
- Fig. 7: eine Sample&Hold-Schaltung mit Integrator,
- Fig. 8: die Zusammenschaltung von Sample&Hold-Schaltung mit Integrator und Gilbert-Multiplizierer,
- Fig. 9: ein Timing Diagramm,
- Fig. 10: eine Blockdiagrammdarstellung der Beschaltung der Sendeantenne einer UWB-Transceiver-Architektur nach einem zweiten Ausführungsbeispiel der Erfindung,
- Fig. 11: ein Blockschaltbild der Beschaltung der Empfangsantenne der UWB-Transceiver-Architektur gemäß dem zweiten Ausführungsbeispiel,
- Fig. 12: eine schematische Darstellung des Schieberegisters zur Realisierung des Ansteuer-Template für die Sende- und Empfangsantenne und das Zeitdiagramm für die zeitlich versetzte Erzeugung von Ansteuersignalen für die Schaltereinheiten der Beschaltungen gemäß Fign. 10 und 11 und
- Fig. 13: die Zeitsignale zur Ansteuerung der Treiber der Beschaltungen gemäß Fign. 10 und 11 zwecks Erzeugung zweier um 90° phasenverschobener Gaußschen Pulse 5-ter Ordnung.

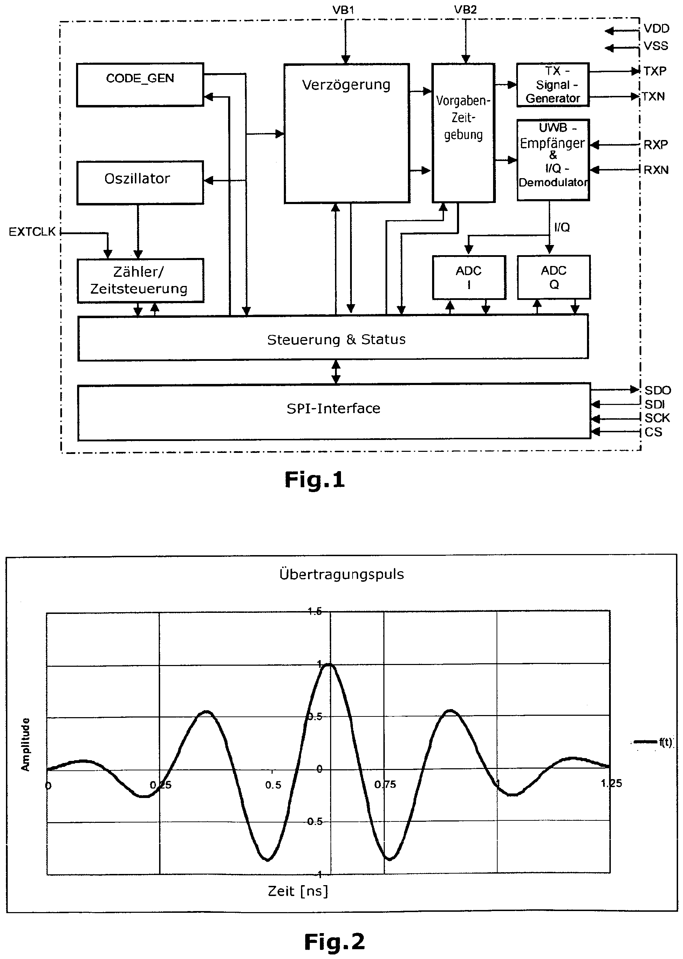

Fig. 1 zeigt einen beispielhaften Auswerteschaltkreis, in dem die erfindungsgemäße Vorrichtung zum Einsatz kommt.

Der Auswerteschaltkreis verfügt über eine dem Fachmann bekannte SPI Schnittstelle mit den üblichen Signalen SDO, SDI, SCK und CS.

Über diese wird eine Control & Status Logik angesprochen und gesteuert, die zum einen die Parametrisierung des Auswerteschaltkreises ermöglicht aber auch die Messwerte an ein hier nicht dargestelltes Datenverarbeitungssystem über die SPI Schnittstelle weitergeben kann.

Das Digitalsystem verfügt über einen Oszillator relativ niedriger Frequenz, dessen Frequenz nicht der der Mittenfrequenz des Ultra-Wide-Band-Signals entspricht sondern erheblich niedriger liegt. Hierdurch wird der Stromverbrauch der Schaltung merklich reduziert. Dies ist aufgrund des im weiteren Verlauf dargestellten erfinderischen Grundgedankens möglich, der einen Verzicht auf einen Oszillator zur Erzeugung der Sendefrequenz ermöglicht.

Ein Counter/Timer sowie weitere Speicherknoten in der Control & Status Logik steuern den Ablauf des Sende und Empfangsvorganges.

Wesentlicher Teil des Auswerteschaltkreises ist der Code-Generator, der eine Bit-Sequenz generiert, die durch die Control und Status Logik an die Sende und Empfangseinrichtung weitergegeben wird.

Das Sendesignal verlässt den Auswerteschaltkreis über die bipolaren Anschlüsse TXP und TXN. Das Empfangssignal erreicht den Schaltkreis über die Anschlüsse RXP und RXN. Von dort gelangt es in den UWB Empfänger (UWB Receiver) und Demodulator.

Von dort gelangt das (immer noch zweiphasige) Signal auf einen zweiphasigen ADC. (ADC I und ADC Q).

Des Weiteren verfügt der Auswerteschaltkreis über eine erste Verzögerungsstrecke für das Code-Signal (Delay) und eine Festlegung des Timings für den durch den Code-Generator generierten Code mittels eines vorgegebenen Templates.

Bei Code-Flanken erzeugt nun der TX Signal Generator Pulse definierter Form. Die Form der Pulse und damit deren Spektrum wird dabei durch die Schaltung vorgegeben. Das bedeutet, dass die Mittenfrequenz des Puls-Spektrums nicht durch einen Oszillator bestimmt wird der zum einen nicht die geforderte Präzision haben würde und zum anderen eine erhebliche Menge elektrischer Energie benötigen würde.

Fig. 2 zeigt einen typischen Burst, der aus einzelnen Pulsen unterschiedlicher Höhe und zeitlicher Lage zusammengesetzt ist. Der Burst weist die Form einer Sinus- bzw. Cosinus-Funktion multipliziert mit einer Gauß-Verteilung auf. Damit gleicht der Burst einer Si-Funktion (sin(x)/x).

Diese Pulse werden nun als Wavelets benutzt, um hierdurch das gewünschte modulierte Sendesignal zu erzeugen. Die einzelnen Pulse werden zeitverzögert erzeugt und gewichtet addiert, so dass die Burst-Funktion entsteht. Damit lässt sich ein Frequenzbereich im insbesondere einstelligen bzw. zweistelligen GHz-Bereich, z.B. von 1 GHz bis 10 GHz oder genauer 3 GHz bis 5 GHz abbilden.

Der durch den Code-Generator definierte Bit-Strom, der typischerweise ein pseudozufälliger Bitstrom ist, bestimmt mit seinen Flanken die zeitliche Position der Pulse.

Durch dynamische Änderung der Beschaltung, kann die Pulsform in Breite und Höhe für verschiedene Flanken verändert werden.

Um orthogonale Bursts senden zu können, können um π/2 verschobene, also beispielsweise um eine halbe Pulsbreite verschobene Pulse eingesetzt werden, die durch eine zweite parallele Modulationsstrecke erzeugt werden. Hierzu wird das digitale Signal des Code-Generators in einer zweiten Verzögerungsleitung um besagte (nicht dargestellte, da dem Fachmann geläufige) Verzögerungsleitung um besagte π/2 verzögert. Diese Methode kann ebenfalls für die Empfangsseite eingesetzt werden.

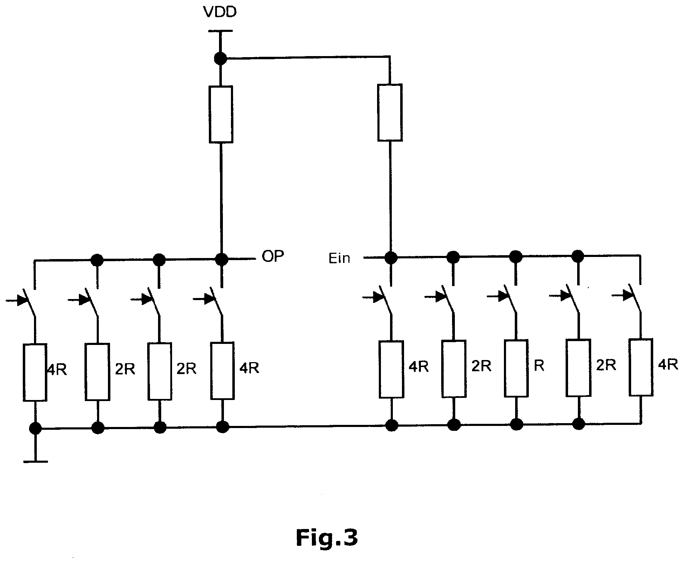

Ein beispielhafter, hier bipolarer Signalgenerator ist in Fig. 3 dargestellt. Die Schalter können beispielsweise als Transistoren ausgeprägt sein. Durch kurzes Schließen der Schalter entsteht jeweils ein vom jeweiligen Widerstand abhängiger Strompuls, der an ON bzw. OP zum Senden abgenommen werden kann. Für jeden Peak des Musterpulses (Fig. 2) wird ein Schalter geschlossen.

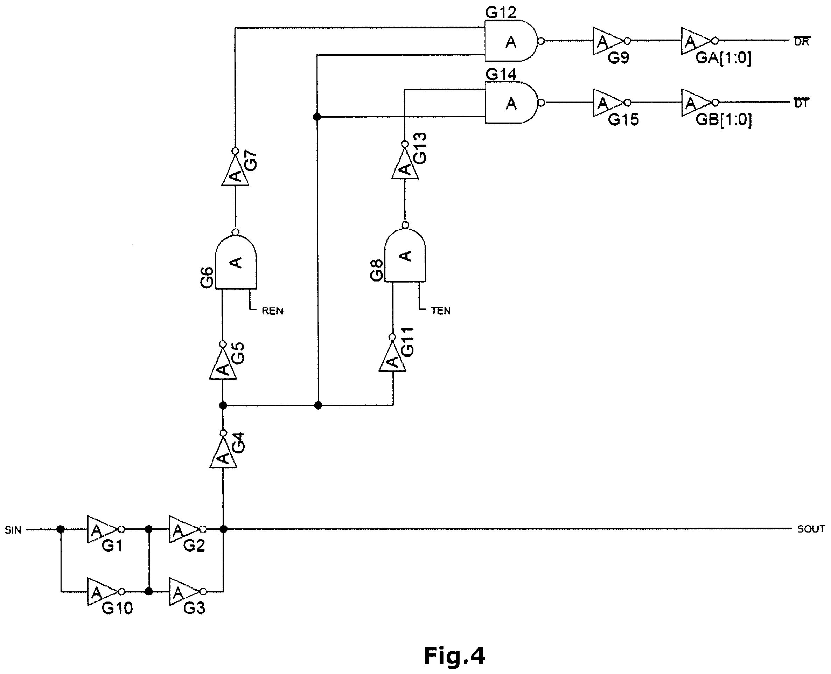

Die Steuerpulse stammen dabei aus einer kurzen Verzögerungskette (Fig. 4). Die Verzögerungsleitung wird dabei durch die Versorgungsspannung VB1 des Blockes DELAY (siehe Fig. 1) kalibriert. Diese bestimmt z.B. die Mittenfrequenz des Pulsspektrums. Um eine Übereinstimmung der spektralen Eigenschaften zu garantieren, wird die gleiche Verzögerungskette sowohl für die Sende-Signal-Generierung als auch für die Template-Erzeugung für die Demodulation verwendet.

Fig. 4 zeigt eine beispielhafte, dem Stand der Technik entsprechenden, digitale Steuerpulsgeneratorstufe, die aus dem bei SIN in die Schaltung eingespeisten Signal des Code-Generators oder einer vorausgehenden Steuerpulsgeneratorstufe zwei bipolare Puls-Signale generiert, die bei DR und DT die Steuerpulsgeneratorstufe jeweils als bipolares Signal wieder verlassen. Das digitale Signal an SIN verlässt verzögert an SOUT wieder die Schaltung und kann von dort wieder in eine folgende Steuerpulsgeneratorstufe eingespeist werden. Durch Aneinanderkettung mehrerer Stufen dieser Art (beispielsweise 20) entstehen mehrere gegeneinander identisch verzögerte, gepulste Steuersignale DR[0..n] und DT[0...n], die jeweils zusätzlich noch bipolar sind.

Die Signale TEN und REN ermöglichen hierbei den Wechsel zwischen Senden und Empfangen.

Die Gatter G1, G2, G10 und G3 verzögern das Signal in jeder Stufe.

Die Gatter G4, G5 und G11 dienen der Entkopplung von Sende und Empfangspulsen dieser Verzögerungsstufe.

Die Gatter G6 und G8 dienen als Tor zur Einschaltung des Sende- bzw. Empfangsbetriebs.

G7, G12, G9 und das mit einem bipolaren Ausgang versehene Gatter GA treiben das bipolare Signal DR im Empfangsbetrieb.

Der Bufferschaltkreis für die nachfolgenden Schalter stellt dabei die Form der Pulse und damit das Spektrum sicher. Gleichzeitig muss die zeitliche Positionierung der Pulse (Timing) entsprechend den anzusteuernden Schaltern zueinander erhalten bleiben.

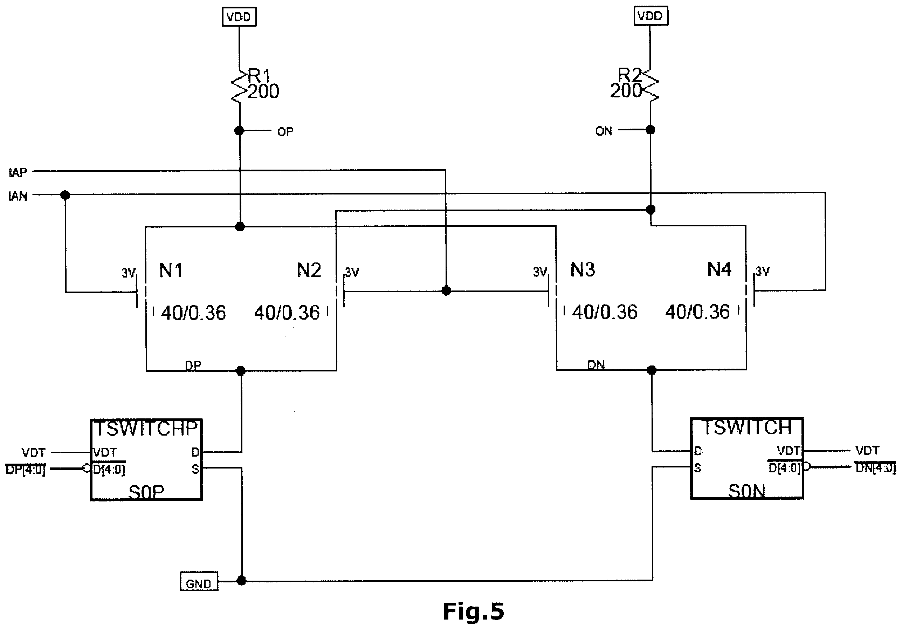

Fig. 5 zeigt einen erfindungsgemäß vorteilhaft verwendeten Gilbert-Multiplizierer auf der Empfängerseite.

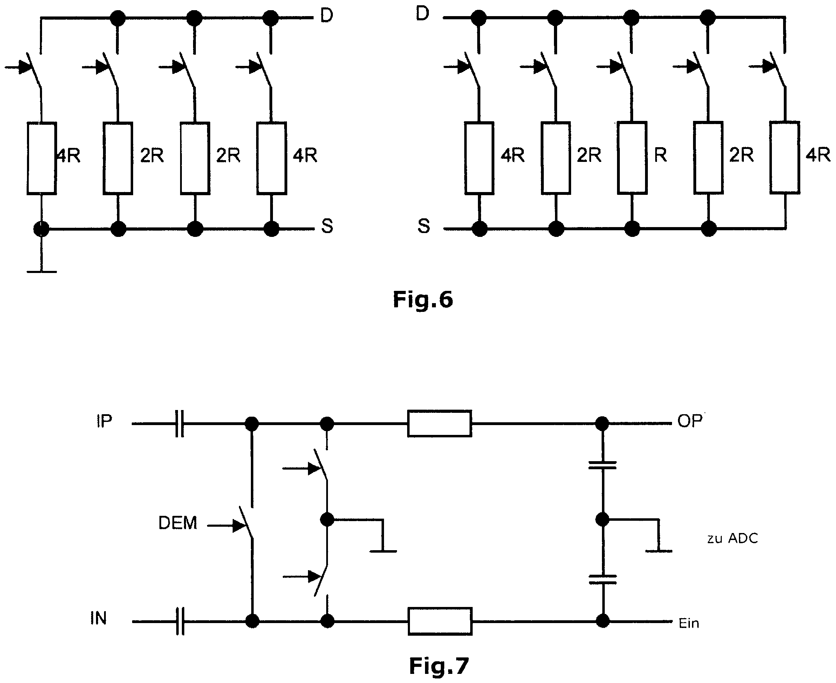

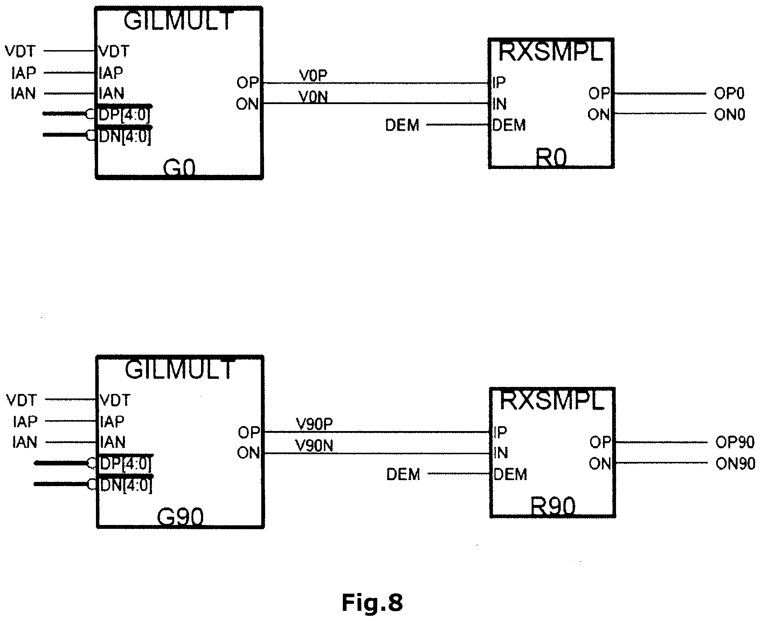

Auf der Empfängerseite wird dieser typischerweise zweimal verwendet (Fig. 8). Dieser Gilbert-Multiplizierer weist zwei Differenzverstärkerstufen mit jeweils zwei Transistorpaaren N1, N2 und N3, N4 auf. Jedes dieser Paare ist mit einer digital gesteuerten Stromquelle versehen (TSWITCHP). Diese sind in Fig. 6 beispielhaft dargestellt. Das Signal VDT spielt im Zusammenhang dieser Anmeldung keine Rolle. Die durch den Steuerpulsgenerator (Fig. 4) erzeugten, zueinander zeitlich verschobenen Pulse werden über den Bus DP und DN mit je einer steuerbaren Stromquelle verbunden.

Die Signale des Busses DP sind dabei eine Untermenge der Signale, die die Kette der Steuerpulsgeneratorstufen liefern. Gleiches gilt für den Bus DN.

Diese Signale steuern die gewichteten und gesteuerten Stromquellen nun so an, dass der Strompuls der einen Stromquelle gegenüber dem Strompuls der anderen Stromquelle innerhalb eines Gilbert-Multiplizierers (Fig. 4) um π verschoben ist. Die Form der resultierenden Strompulse in die Differenzverstärkerstufe hinein entspricht dabei wieder beispielsweise Fig. 2.

Um dies zu gewährleisten, wird die Verzögerung der Steuerpulsgeneratorstufen durch die Gatter G1, G2, G10 und G3 so gewählt, dass diese jeweils einer Verzögerung um n/2 entsprechen.

Das bedeutet, dass Pulsform und Verzögerung nicht unabhängig voneinander gewählt werden. Vielmehr kann der Fachmann durch Simulation und Berechnung sicherstellen, dass diese im gewünschten Betriebsbereich des Systems in etwa diese Anforderung erfüllen.

Hierdurch wird durch die Verzögerung der Steuerpulsgeneratoren in Kombination mit dem Timing-Template, das aus diesen Angebot an Verzögerungen einige auswählt und mit den gewichteten Stromquellen (siehe Fig. 6) verbindet, ein Grundmuster an orthogonalen Wavelets bereitgestellt, ohne dass hierfür ein lokaler Oszillator der Trägerfrequenz notwendig wäre.

Wenn man nun beispielsweise die Ausgänge des Steuerpulsgenerators entsprechend der erhaltenen Verzögerung durchnummeriert, so bedeutet das zuvor beschriebene, dass die Leitungen des Busses DP des ersten Gilbert-Multiplizierers mit den geradzahligen Verzögerungsgliedern (Steuerpulsgeneratorstufenausgängen) verbunden sind während die korrespondierenden Leitungen seines Busses DN mit den um zwei erhöhten Ausgängen verbunden sind. Für den zweiten Gilbert-Multiplizierer bedeutet dies, dass die Leitungen des seines Busses DP mit gegenüber den geradzahligen um eins erhöhten ungeradzahligen Verzögerungsgliedern (Steuerpulsgeneratorstufenausgängen) verbunden sind während die korrespondierenden Leitungen seines Busses DN mit den um zwei erhöhten ebenfalls ungeradzahligen Ausgängen verbunden sind.

Als Ausgangssignal der beiden Gilbert-Mischer ergeben sich somit je zwei Signale ON und OP, die um 0, π/2, π und 3/2π verzögert eingespeisten Template im Antennensignal, das jeweils an IAP und IAN eingespeist wird, wiedergeben.

Um nun ausschließlich eine bestimmte Reflektion ausfiltern zu können, werden ON und OP jedes Paars in jeweils einer Sample- and Hold-Schaltung (Fig. 7) gespeichert. Hierzu werden durch die Kontrolllogik die drei Schalter geschlossen. Die Eingangskondensatoren werden geladen. Werden die Schalter geöffnet, so wird deren Inhalt auf die beiden Ausgangskondensatoren übertragen.

Fig. 8 zeigt die Zusammenschaltung je einer Sample & Hold-Schaltung mit je einem Gilbert-Multiplizierer.

Das eine Paar aus ON und OP bildet das bipolare Signal I, das andere das bipolare Signal Q.

Diese niederfrequenten Signale können nun durch je einen Analog/DigitalKonverter (ADC) in je ein digitales Statuswort gewandelt und ausgelesen werden. (siehe Fig. 1)

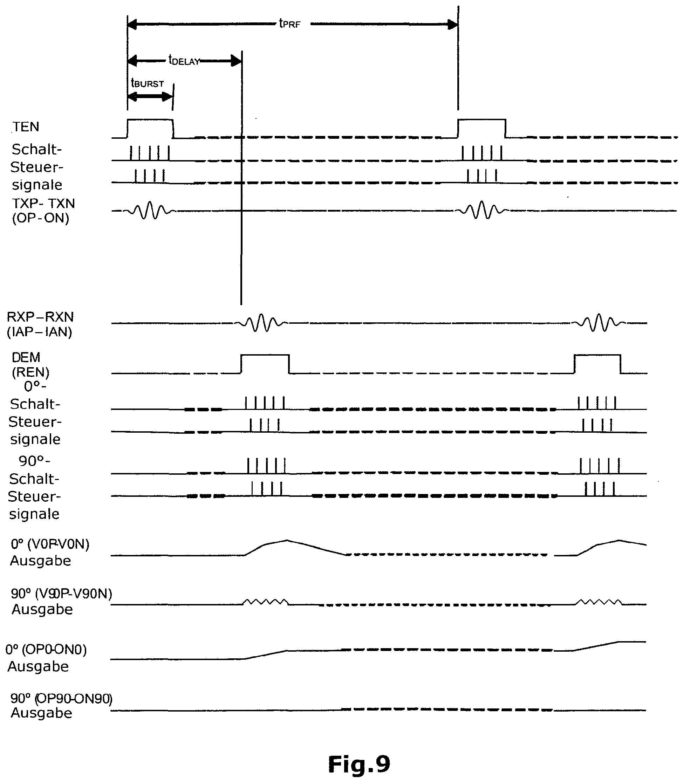

Fig. 9 zeigt noch einmal das verwendete Timing. Während der Burst-Dauer t_{Burst} wird das Enable-Signal TEN für den Sendevorgang aktiv (high). In dieser Zeit werden durch die gewichteten Schalter des Sende-Generators (Fig. 3) Pulse auf ON und OP erzeugt wodurch das durch ON und OP gebildete bipolare Signal TXP-TXN (OP-ON) Bursts, wie in Fig. 2 dargestellt, zeigt. Die in diesem Timing-Diagramm gemäß Fig. 9 im ersten Diagramm unterhalb des Intervalls t_{BURST} gezeigten fünf Pulse bestimmen die fünf positiven Sinushalbwellen, während die unter diesen fünf Pulsen gezeigten, "auf Lücke" zu diesen gelegten vier Pulse die negativen Sinushalbwellen des Burst-Signals nach Fig. 2 bestimmen und bilden.

Zwischen zwei Bursts vergeht eine Zeit t_{PRF}, die beliebig lang sein kann.

Nach dem Start des Sendepulses trifft der reflektierte (und in der Regel massiv gestörte) Puls wieder an der Empfangsantenne ein. Diese liefert das Signal RXP-RXN (IAP-IAN). Durch systematisches Suchen kann die Verzögerung t_{Delay} zwischen dem Start des Sendepulses und dem Beginn der Empfangsphase nun so eingestellt werden, dass das Enable Signal für den Empfänger DEM (REN) mit dem Eintreffen des Pulses aktiv wird.

Im Gegensatz zum Sendefall werden nun vier Puls-Familien generiert. Zwei entsprechen denen des Senders. Die anderen beiden entsprechen ebenfalls diesen, sind aber gegenüber den ersten beiden um 90° phasenverschoben. Mit diesen Signalen werden die besagten zwei Gilbert-Multiplizierer angesteuert, die die Signale 0° (VOP-V0N) und 90°(V90P-V90N) liefern. Diese Signale werden durch die besagten zwei Sample & Hold Schaltungen abgetastet. Diese liefern die Signale 0°(OP0-ON0) und 90°(OP90-ON90).

Das Diagramm zeigt, wie durch Integration der Wert von 0°(OP0-ON0) ansteigt. Aufgrund der Phasenlage des Eingangssignals RXP-RXN(IAP-IAN) ändert sich der Pegel von 90°(OP90-ON90) nicht.

### Vorteile der Erfindung gegenüber dem Stand der Technik

Die unteren Signale der Gilbert-Multiplizierer (Fig. 5) werden im Stand der Technik für die Einspeisung des Antennensignals verwendet. Durch die erfindungsgemäße Verwendung der unteren Stufe für einen Strompuls-Wavetet-Generator und Einspeisung des Antennensignals in die obere Multiplizierer-Stufe kann die Schaltung komplett in NMOS Transistoren realisiert werden, was einen Flächen und Geschwindigkeitsgewinn zur Folge hat.

Der Gilbert-Multiplizierer zur Demodulation des Spread-Spectrum-Signals ist dadurch charakterisiert, dass er aus zwei Gilbert-Multiplizieren besteht, die jeder für sich mit Hilfe eines orthogonalen Templates das Eingangssignal demodulieren und dabei das Template über die Transistorgrößen in der Stromquelle (Fig. 6) implementiert ist.

Von besonderem Vorteil ist, dass kein lokaler Oszillator für die Puls-Mittenfrequenz notwendig ist, weil die Pulsform durch die Schaltung bestimmt wird. Pulsform in Breite und Höhe werden durch die Schaltung bestimmt.

Da das Template für den Sende- und Empfangszweig identisch generiert werden, stimmen die Pulsformen für Sende- und Empfangstemplate überein. Damit stimmen auch die Spektren überein.

Ein weiterer Vorteil ist darin zu sehen, dass durch das UWB-Radar die Detektion von Körpern im Raum mittels reflektierter Signale und der Gewinnung des reflektierten Signals aus einem stark gestörten Signalstrom möglich ist.

Durch entsprechende Layout-Maßnahmen kann sichergestellt werden, dass die Stromquellen bzw. Schalterwiderstände im Sende- und Empfangsast matchen.

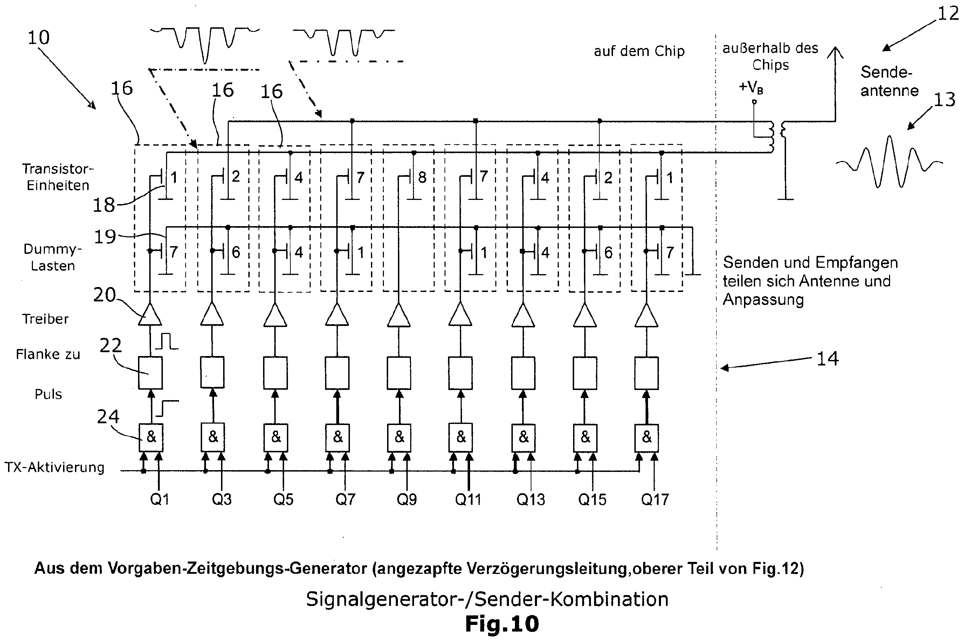

### Sendewellenform-Erzeugung für Ultrabreitband-Radar (Fig. 10)

Für diese Ausführungsform wurde eine Gaußsche pulsartige Wellenform 5ter Ordnung gemäß Fig. 2 bzw. 14 gewählt. Das Signal kann zahlreichen derivativen Prozessen unterzogen werden (Senden, Reflexion, Empfangen), ohne seine Korrelationseigenschaften zu verlieren. Bei praktischen Anwendungen kann der Fall eintreten, dass die Wellenform bis zu fünf derivativen Prozesse erfährt, bevor sie die Empfangsantenne erreicht.

Für die Übertragung bietet die Wellenform das erforderliche Spektrum ohne eine zusätzliche Filterung (Vfg. 9/2010, Allgemeinzuteilung von Frequenzen für die Nutzung durch Ultrawideband-Anwendungen geringer Leistung).

Das Sendesignal wird durch gewichtete Schalter erzeugt, die mittels teilweise überlappender Signale gesteuert werden.

In dem Sender erfolgt ein Stromverbrauch nur während des Erzeugens und des Sendens des Signals.

Die an einem Schalter angeführte Zahl gibt an, wie viele z.B. aus acht Transistoren bestehende Einheiten parallelgeschaltet sind. Das R_{SDON} eines Transistors ist in diesem Beispiel SR. So wie "8" für R steht, so steht eine "1" für 8*R.

Zur Treiberlastanpassung werden nicht verwendete NMOS-Transistoren mit GND (als Dummy-Last bezeichnet) verbunden.

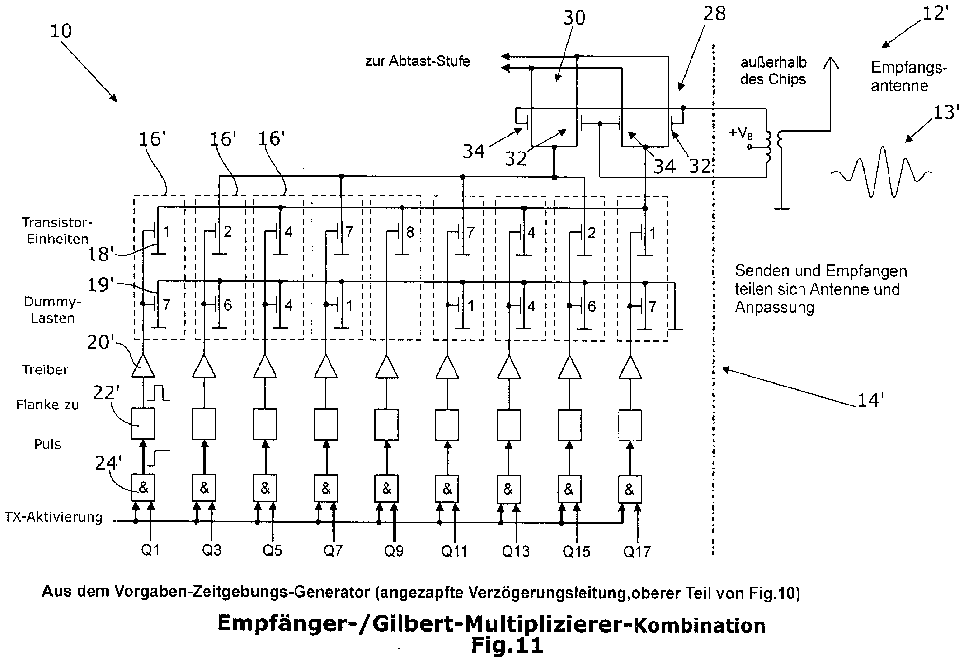

### Empfänger mit Korrelator/Demodulator für Ultrabreitband-Radar (Fig. 11)

Der Empfänger besteht aus einem Gilbert-Multiplizierer. Das Empfangssignal wird an die oberen Transistoren der Multipliziererschaltung angelegt, so dass die gleichen Pins gemeinsam mit dem Sender-Ausgang benutzt werden können. Die DC-Vorspannung und die Anpassungs-Anforderungen sind die gleichen. Der untere Bereich enthält den gleichen Typ gewichteter Schalter, die durch teilweise überlappende Signale gesteuert werden, wie der Sender.

Es sind zwei identische Gilbert- Multiplizierer erforderlich, um die Größe des Empfangssignals zu berechnen. Eine der Schaltungen wird mittels der in Phase liegenden Pulse gesteuert (Q1, Q3, Q5, Q7, Q9, Q11, Q13, Q15, Q17), und die andere mittels um 90° phasenverschobener Signale (Q01, Q2, Q4, Q6, Q8, Q10, Q12, Q14, Q16).

In dem Sender erfolgt ein Stromverbrauch nur während des Erzeugens und des Sendens des Signals. Der Empfänger/Gilbert-Multiplizierer ignoriert jedes Signal (einschließlich des Sendesignals), das nicht in das Korrelations- (Zeit-) Fenster fällt.

Die an einem NMOS-Transistor (Schalter) angeführte Zahl gibt an, wie viele Einheiten parallelgeschaltet sind. So wie "8" für R steht, so steht eine "1" für 8*R.

Zur Treiberlastanpassung werden nicht verwendete NMOS-Transistoren mit GND (als "Dummy-Last" bezeichnet) verbunden.

### Zeitsteuerungsvorgaben-Generator

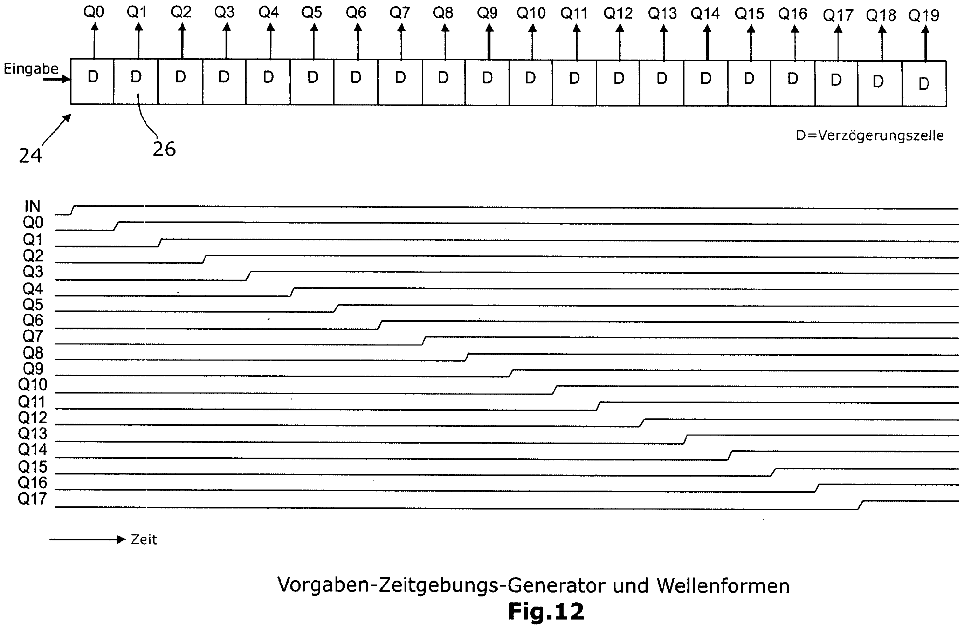

Es wird Bezug genommen auf Fig. 12.

Der Zeitsteuerungsvorgaben-Generator ist erforderlich, um eine Abfolge von Flanken für die Flanken-zu-Puls-Konverter zu erzeugen. Es wird eine angezapfte Verzögerungsleitung ("tapped delay line") verwendet. Die Ausbreitungsgeschwindigkeit bestimmt die Mittenfrequenz des Sende-/Vorgaben-Spektrums und kann mittels einer DC-Vorspannung kalibriert werden. Die Verzögerungszellen mit den Ausgängen Q18 und Q19 sind Dummies für Anpassungszwecke.

Ein sogenannter "Zeitsteuerungsvorgaben-Generator", der die angezapfte Verzögerungsleitung aufweist, wird verwendet, um die beiden Vorgaben-Signale für den Empfänger zu erzeugen. Es wird ein Puls aus der Flanke des Signals erzeugt, das sich durch den Zeitsteuerungsvorgaben-Generator (Verzögerungsleitung) ausbreitet. Angepasste Treiber (0 ... 17) steuern die gewichteten Schalter in der Sende- und Empfangsschaltung.

Der Empfänger sendet zwei Signale um exakt 90° phasenverschoben aus. Die Mittenfrequenz wird mittels der Vorspannung für den Zeitsteuerungsvorgaben-Generator eingestellt. Die Kalibrierung wird durchgeführt, indem die Verzögerungsleitung in eine Rückkopplungsschleife geschaltet wird und die resultierende Oszillatorfrequenz getunt wird.

Um eine exakte Anpassung der Zeitsteuerung zu gewährleisten, wird der (physisch) gleiche Zeitsteuerungsvorgaben-Generator verwendet, um die Zeitsteuerung sowohl für die Sende- als auch für die Empfangs-Vorgabe zu generieren.

### Zeitsteuerungsvorgaben-Generator für ein in Phase liegendes Signal und für ein um 90° phasenverschobenes Signal

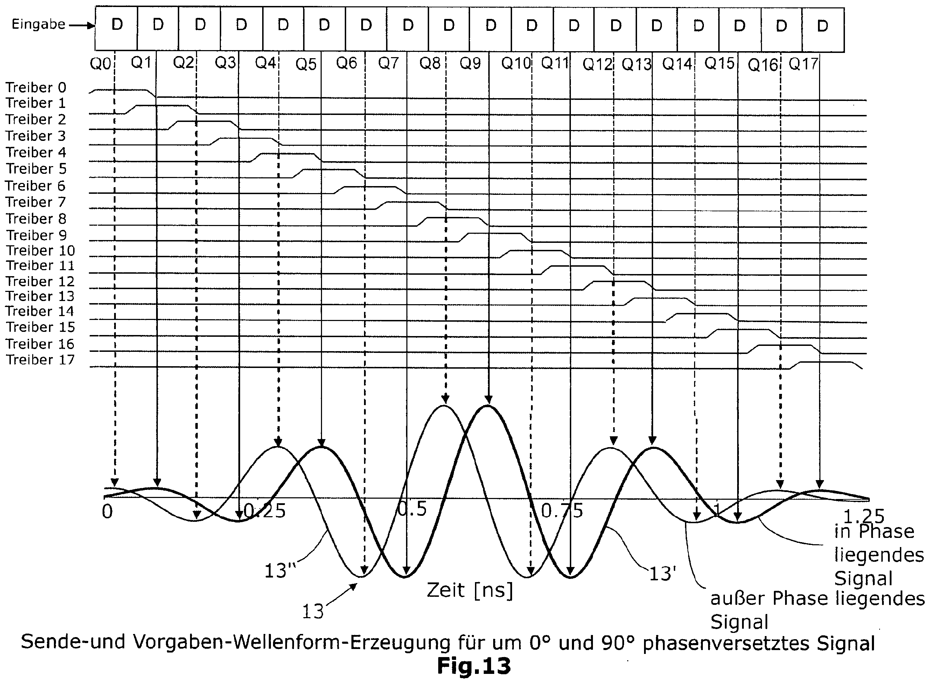

Es wird Bezug genommen auf Fig. 13.

Das in Phase liegende Signal wird z.B. durch den ungeradzahligen Ausgang des Zeitsteuerungsvorgaben-Generators erzeugt. Das um 90° phasenverschobene Signal wird z.B. durch den geradzahligen Ausgang des Zeitsteuerungsvorgaben-Generators erzeugt.

Gemäß dem Ausführungsbespiel der Fign. 10 bis 13 weist die UWB-Einrichtung 10, die in diesem Ausführungsbeispiel als Radar ausgebildet sein kann, eine Sendeantenne 12 auf, die periodisch bzw. in anderer Weise wiederholt Sendepulse mit Gaußscher 5-ter Ordnung 13 aussendet. Die Erzeugung dieser Pulse erfolgt erfindungsgemäß ohne Verwendung eines Oszillators, was den Vorteil mit sich bringt, dass der Energieaufwand reduziert ist. Bei dem Ausführungsbeispiel der Fign. 10 bis 13 werden die Sendepulse durch zeitlich abgestimmte Erzeugung von Einzelimpulsen entgegengesetzter Polarität und unterschiedlicher Amplitude erzeugt. Hierzu dient auf Seiten der Sendeantenne 12 eine Beschaltung 14, wie sie in Fig. 10 gezeigt ist. Gemäß Fig. 10 weist die Beschaltung 14 mehrere Schaltereinheiten 16 auf, die jeweils eine gleiche Anzahl von Schalttransistoren 18 umfassen. In diesem Ausführungsbeispiel weist jede Schaltereinheit 16 acht Schalttransistoren 18 auf. Die Schalttransistoren 18 haben im Wesentlichen den gleichen Einschaltwiderstand, was bedeutet, dass die Werte der Einschaltwiderstände um maximal 10 %, vorzugsweise 5 % voneinander abweichen.

Wie in Fig. 10 gezeigt, bilden die in der oberen Reihe dargestellten Schalttransistoren 18 die gewichteten Widerstände, wobei die "Ziffer 1" neben einem Schalttransistor 18 angibt, dass der Widerstand durch lediglich einen der in diesem Ausführungsbeispiel acht Schalttransistoren 18 realisiert ist. Dieser Widerstand beträgt in diesem Ausführungsbeispiel 8R, also das Achtfache des Widerstandes R. Acht parallelgeschaltete Schalttransistoren 18 ergeben damit einen Widerstand der Größe R. Vier parallelgeschaltete Schalttransistoren 18 führen dann also zu einem Widerstand von 2R. Zwei parallelgeschaltete Schalttransistoren 18 ergeben demzufolge dann einen Widerstandswert von 4R. Die pro Schaltereinheit 16 zur Realisierung des jeweiligen gewichteten Widerstandes nicht benötigten Schalttransistoren 18 sind in Fig. 10 in der zweiten Reihe als Dummy-Schalttransistoren 19 parallel und nach Masse geschaltet.

Dadurch, dass pro Schaltereinheit 16 eine unterschiedliche Anzahl von Schalttransistoren 18 parallelgeschaltet sind, bilden die Schaltereinheiten 16 gewichtete Widerstände. Werden diese gewichteten Widerstände nun zeitlich versetzt über Treiber 20 angesteuert, die zeitlich unterschiedlich getriggert werden (siehe die Funktionsblöcke 22,23 der Fig. 10), gelingt es, den bei 13 gezeigten Gaußschen Sendepuls 5-ter Ordnung zu erzeugen.

Die Ansteuerung der Treiber 20 erfolgt mit Hilfe des Zeitsteuerungsgenerators 24 gemäß Fig. 12. Hierbei handelt es sich um eine Kette von Verzögerungsgliedern 26 mit im Wesentlichen identischer Verzögerungszeit. Die Ausgänge Q0 bis Q19 sind mit Treibern und über diese mit Schaltereinheiten 16 verbunden, wie es Fig. 10 zeigt. Dabei ist zu beachten, dass die Beschaltung 14 gemäß Fig. 10 wiederholt jeweils ein Paar von Gaußschen Pulsen 5-ter Ordnung erzeugt, die pro Paar um 90° phasenverschoben sind, wie es in Fig. 13 gezeigt ist (siehe die Wellenformen 13' und 13" in Fig. 13). Darüber hinaus dient der Zeitsteuerungsgenerator 24 auch der Erzeugung der identischen Gaußschen Pulse 5-ter Ordnung im Empfangszweig der UWB-Einrichtung 10, was in Fig. 11 gezeigt ist. Die Beschaltung 14' gemäß Fig. 11 ist letztendlich identisch mit der Beschaltung 14 gemäß Fig. 10, so dass zu Korrelationszwecken, wie es bei der Anwendung bei einem UWB-Radar der Fall ist, zeitlich genau aufeinander abgestimmte, identische Signale erzeugt werden können. Insoweit sind in Fig. 11 identische bzw. funktionsgleiche Bauelemente und Funktionsblöcke mit den gleichen Bezugszeichen, jedoch einfach gestrichen, versehen, wie in Fig. 10.

Zusätzlich weist die Beschaltung 14' der Empfangsantenne 12' zwei Gilbert-Multiplizierer 28,30 auf, die jeweils ein Paar von Transistoren 32 bzw. 34 umfassen.

In den Fign. 12 und 13 sind die Signalverläufe an den Ausgängen des Zeitsteuerungsgenerators 24 sowie an den Ausgängen der Treiber 20,20' gezeigt. Zusammen mit den gewichteten Widerständen, die durch die Schaltereinheiten 16 realisiert sind, ergibt sich damit sowohl senderseitig als auch empfängerseitig eine zeitliche Abfolge jeweils zweier, um 90° verschobener Gaußscher Sendepulse 5-ter Ordnung, wie es in Fig. 1 gezeigt ist.

### Hauptaspekte der Erfindung

Erzeugen einer Wellenform für Ultrabreitband-Radar.

Für die Übertragung sollte die Wellenform das erforderliche Spektrum aufweisen, ohne dass eine zusätzliche Filterung erfolgt.

Das Signal sollte in der Lage sein, sich zahlreichen derivativen Prozessen unterziehen zu lassen (Senden, Reflexion, Empfangen), ohne seine Korrelationseigenschaften zu verlieren. Bei praktischen Anwendungen kann der Fall eintreten, dass die Wellenform bis zu fünf derivativen Prozesse erfährt, bevor sie den Empfänger erreicht. Deshalb wird vorzugsweise ein Gaußscher Impuls 5ter Ordnung verwendet. Diese Funktion erleidet keine signifikante Deformation, wenn sie übertragen (erste Zeitableitung), reflektiert (zweite Zeitableitung) und empfangen wird (dritte Zeitableitung).

Der Stromverbrauch des Senders ist so klein wie möglich.

Die charakteristische Form des Sendesignals wird nicht aus einer Spannungsanstiegszeit gebildet. Die Form wird gemäß der vorliegenden Erfindung mittels gewichteter Schalter erzeugt, die durch teilweise überlappende Signale gesteuert werden, welche direkt die erforderliche Wellenform ergeben.

### Vorteile der Erfindung

Betrieb mit niedrigem Energiebedarf
Robustes Konzept
Einfache Implementierung
Niedrige Komplexität
nur sehr kleine Chipfläche erforderlich
keine komplexen Filter erforderlich
Kein LNA (Low Noise Amplifier) erforderlich
kein GHz-Oszillator, da der Sende-Puls digital erzeugt wird

## Patentansprüche

1. Verfahren zum Betreiben einer mindestens eine Sendeantenne und mindestens eine Empfangsantenne aufweisenden UWB-Einrichtung, mit den folgenden Schritten:
- Ansteuern der Sendeantenne (12) oder der Empfangsantenne (12') mit einem Ansteuerpulssignal (13,13'), das eine Folge von im Wesentlichen sinusförmigen Pulsen alternierender Polarität und unterschiedlicher Amplitude aufweist und insbesondere die Wellenform eines Gaußschen Pulssignals 5ter Ordnung aufweist, **dadurch gekennzeichnet, dass**
- der Sendeantenne (12) alternierend Strompulse unterschiedlicher Polarität und verschiedener Größe zugeführt werden, indem mit der Sendeantenne (12) gekoppelte elektronische erste Schaltereinheiten (16), die den Amplituden der zu erzeugenden Pulse zugeordnete Widerstände aufweisen, ein- und ausgeschaltet werden,
- wobei jede erste Schaltereinheit (16) eine vorgegebene, insbesondere gleiche, Anzahl an ersten Schalttransistoren (18,19) mit jeweils gleichen Einschaltwiderstandswerten (R) aufweist,
- wobei der Widerstand einer ersten Schaltereinheit (16) entweder durch Verwendung lediglich eines der ersten Schalttransistoren (18,19) oder durch Verwendung mehrere erster Schalttransistoren (18,19), die parallel geschaltet werden, eingestellt wird und
- wobei die ersten Schaltereinheiten (16) gemäß einem vorgebbaren Zeitschema sequenziell und jeweils für ein Ansteuerzeitintervall vorbestimmter Länge angesteuert werden.

2. Verfahren nach Anspruch 1, **dadurch gekennzeichnet, dass** die Ansteuerzeitintervalle zweier zeitlich aufeinanderfolgend angesteuerten ersten Schaltereinheiten (16) einander überlappen oder zeitlich beabstandet sind.

3. Verfahren nach Anspruch 1 oder 2, **dadurch gekennzeichnet, dass** das Pulssignal zwei um 90° phasenverschobene, im Wesentlichen gleiche Folgen von im Wesentlichen gleichen sinusförmigen Pulsen aufweist.

4. Verfahren nach einem der Ansprüche 1 bis 3, **dadurch gekennzeichnet, dass** zum Zweck der Korrelation eines von der Empfangsantenne (12') empfangenen Empfangssignals mit dem Sendesignal ein Korrelationssignal erzeugt wird, und zwar genauso wie das Sendesignal und mittels den ersten Schaltereinheiten (16) gleichender zweiter Schaltereinheiten (16), die sequenziell genauso wie die ersten Schaltereinheiten (16) gemäß dem Zeitschema angesteuert werden.

5. Verfahren nach einem der Ansprüche 1 bis 4, **dadurch gekennzeichnet, dass** die Empfangsantenne (12') mit mindestens einem Gilbert-Multiplizierer (28,30) mit jeweils einer Differenzstufe aus einem Paar von Transistoren (32,34) verbunden ist, wobei mit der Differenzstufe des Gilbert-Multiplizierers (28,30) ein- und ausschaltbare zweite Schaltereinheiten (16) verbunden sind, über die dem Gilbert-Multiplizierer (28,30) ein zum Ansteuerpulssignal (13,13') für die Sendeantenne (12) gleiches Pulssignal zugeführt wird, wobei jede zweite Schaltereinheit (16) eine vorgebbare, insbesondere gleiche, Anzahl an zweiten Schalttransistoren (18,19) mit jeweils gleichen Einschaltwiderstandswerten (R) aufweist, wobei der Widerstand einer zweiten Schaltereinheit (16) entweder durch Verwendung lediglich eines der zweiten Schalttransistoren (18,19) oder durch Verwendung mehrere zweiter Schalttransistoren (18,19), die parallel geschaltet werden, eingestellt wird und wobei die zweiten Schaltereinheiten (16) gemäß dem gleichen Zeitschema wie die ersten Schaltereinheiten (16) sequenziell und für das Ansteuerzeitintervall vorbestimmter Länge angesteuert werden.

6. Verfahren nach Anspruch 3 und 5, **dadurch gekennzeichnet, dass** die Empfangsantenne (12') mit einem zweiten Gilbert-Multiplizierer gekoppelt ist, wobei dem einen der beiden Gilbert-Multiplizierer (28,30) ein mit dem Ansteuerpulssignal (13,13') für die Sendeantenne (12) gleiches Pulssignal und dem anderen der beiden Gilbert-Multiplizierern (28,30) das zu diesem Pulssignal um 90° phasenverschobene Pulssignal zugeführt wird.

7. Verfahren nach einem der Ansprüche 1 bis 6, **dadurch gekennzeichnet, dass** sämtliche Schalttransistoren (18,19) jeweils einen Einschalt-Widerstandswert aufweisen, wobei die Abweichung der Einschalt-Widerstandswerte von einem vorgegebenen Referenzwert maximal 10 %, vorzugsweise maximal 5 % beträgt.

## Claims

1. A method for operating a UWB device having at least one transmitting antenna and/or at least one receiving antenna, said method comprising the following steps:
- controlling the transmitting antenna (12) or the receiving antenna (12') with a control pulse signal (13,13') having a sequence of substantially sinusoidal pulses of alternating polarity and differing amplitudes and particularly having the waveform of a fifth-order Gaussian pulse signal,
**characterized in that**
- the transmitting antenna (12) is alternately supplied with current pulses of differing polarity and differing magnitude by switching on and off first electronic switch units (16) that are coupled to the transmitting antenna (12) and have resistances associated with the amplitudes of the pulses to be generated,
- wherein each first switch unit (16) has a specifiable, particularly equal, number of first switching transistors (18,19), each having substantially identical on-state resistance values (R),
- wherein the resistance of a first switch unit (16) is adjusted either by using only one of the first switching transistors (18,19) or by using a plurality of first switching transistors (18,19) which are connected in parallel, and
- wherein the first switch units (16) are controlled sequentially according to a specifiable temporal schema and each for a control time interval of predetermined length.

2. The method according to claim 1, **characterized in that** the control time intervals of two first switch units (16) being controlled temporally sequentially are mutually overlapping or are temporally spaced.

3. The method according to claim 1 or 2, **characterized in that** the pulse signal comprises two substantially identical sequences, phase-shifted by 90°, of substantially identical sinusoidal pulses.

4. The method according to any one of claims 1 to 3, **characterized in that**, for correlation of a receive signal received by the receiving antenna (12') with the transmit signal, a correlation signal is generated, notably in the same manner as the transmit signal and by use of second switch units (16) similar to the first switch units (16), said second switch units being sequentially controlled according to the temporal schema in the same manner as the first switch units (16).

5. The method according to any one of claims 1 to 4, **characterized in that** the receiving antenna (12') is connected with at least one Gilbert multiplier (28,30) comprising a respective differential stage consisting of a pair of transistors (32,34), wherein the differential stage of the Gilbert multiplier (28,30) has second switch units (16) connected to it which can be switched on and off and via which a pulse signal is supplied to the Gilbert multiplier (28,30) that is substantially similar to the control signal (13,13') for the transmitting antenna (12), wherein each second switch unit (16) comprises a specifiable, particularly identical number of second switch transistors (18,19) each having substantially the same resistance value (R), wherein the resistance of a second switch unit (16) is set either by use of only one of the second switch transistors (18,19) or by use of a plurality of second switch transistors (18,19) which are connected in parallel, and wherein the second switch units (16) are controlled according to substantially the same temporal schema as the first switch units (16) in a sequential manner and with predetermined length for the control time interval.

6. The method according to claims 3 and 5, **characterized in that** the receiving antenna (12') is coupled to a second Gilbert multiplier, one of the two Gilbert multipliers (28,30) being supplied with a pulse signal substantially identical with the control pulse signal (13,13') for the transmitting antenna (12) and the other one of the two Gilbert multipliers (28,30) being supplied with a pulse signal shifted in phase by 90° relative to said pulse signal.

7. The method according to any one of claims 1 to 6, **characterized in that** all switch transistors (18, 19) have a respective switch-on resistance value, the deviation of the switch-on resistance values from a specifiable reference value being maximally 10 %, preferably maximally 5 %.

## Revendications

1. Procédé pour faire fonctionner un équipement à bande ultra large comportant au moins une antenne d'émission et au moins une antenne de réception, avec les étapes suivantes :
- commander l'antenne d'émission (12) ou l'antenne de réception (12') avec un signal de commande à impulsions (13, 13') qui comporte une série d'impulsions essentiellement sinusoïdales de polarité alternante et d'amplitudes différentes et qui présente notamment la forme d'ondes d'un signal à impulsions gaussien de cinquième ordre,
**caractérisé en ce que**
- des impulsions de courant de polarités différentes et d'envergures différentes sont acheminées de manière alternante à l'antenne d'émission (12) en
allumant et arrêtant des premières unités électroniques de commutateurs (16) couplées à l'antenne d'émission (12) qui comprennent des résistances associées aux amplitudes des impulsions à engendrer,
- chaque première unité de commutateurs (16) comprenant un nombre prédéterminé, notamment un nombre égal, de transistors de commutation (18, 19) ayant des valeurs de résistance de fonctionnement (R) égales,
- la résistance d'une première unité de commutateurs (16) étant réglée soit par utilisation d'un seul des premiers transistors de commutation (18, 19) soit par utilisation de plusieurs premiers transistors de commutation (18, 19) qui sont connectés en parallèle, et
- les premières unités de commutateurs (16) étant commandées de manière séquentielle et pour un intervalle de temps de commande de longueur prédéterminée, selon un schéma temporel pouvant être prédéterminé.

2. Procédé selon la revendication 1, **caractérisé en ce que** les intervalles de temps de commande de deux premières unités de commutateurs (16) commandées dans le temps l'une à la suite de l'autre se chevauchent ou sont espacés dans le temps.

3. Procédé selon la revendication 1 ou 2, **caractérisé en ce que** le signal à impulsions comprend deux suites essentiellement égales et déphasées de 90° l'une par rapport à l'autre, d'impulsions sinusoïdales essentiellement identiques.

4. Procédé selon l'une des revendications 1 à 3, **caractérisé en ce que**, à des fins de corrélation d'un signal de réception reçu par l'antenne de réception (12') avec le signal d'émission, un signal de corrélation est engendré, et cela de la même manière que le signal d'émission et à l'aide de deuxièmes unités de commutateurs (16) ressemblant aux premières unités de commutateurs (16), qui sont commandées de manière séquentielle selon le schéma temporel tout comme les premières unités de commutateurs (16).

5. Procédé selon l'une des revendications 1 à 4, **caractérisé en ce que** l'antenne de réception (12') est reliée à au moins un multiplicateur de Gilbert (28, 30) ayant chacun un étage différentiel constitué d'une paire de transistors (32, 34), des deuxièmes unités de commutateurs (16), adaptées pour pouvoir être allumées et arrêtées, étant reliées à l'étage différentiel du multiplicateur de Gilbert (28, 30), par lesquelles un signal à impulsions est acheminé au multiplicateur de Gilbert (28, 30) qui est le même que le signal de commande à impulsions (13, 13') pour l'antenne d'émission (12), chaque deuxième unité de commutateurs (16) ayant un nombre pouvant être prédéterminé, notamment un nombre égal, de deuxièmes transistors de commutation (18, 19) ayant les mêmes résistances de fonctionnement (R), la résistance d'une deuxième unité de commutateurs (16) étant réglée soit par utilisation d'un seul des deuxièmes transistors de commutation (18, 19) soit par utilisation de plusieurs deuxièmes transistors de commutation (18, 19) qui sont connectés en parallèle, et les deuxièmes unités de commutateurs (16) étant commandées de manière séquentielle et pour l'intervalle de temps de commande de longueur prédéterminée, selon le même schéma temporel que les premières unités de commutateurs (16).

6. Procédé selon la revendication 3 et 5, **caractérisé en ce que** l'antenne de réception (12') est couplée à un deuxième multiplicateur de Gilbert, un signal à impulsions ressemblant au signal de commande à impulsions (13, 13') pour l'antenne d'émission (12) étant acheminé à un des deux multiplicateurs de Gilbert (28, 30) et le signal à impulsions déphasé de 90° par rapport au premier signal à impulsions étant acheminé à l'autre des deux multiplicateurs de Gilbert (28, 30).

7. Procédé selon l'une des revendications 1 à 6, **caractérisé en ce que** tous les transistors de commutation (18, 19) présentent, chacun, une valeur de résistance de fonctionnement, l'écart entre les valeurs de résistance de fonctionnement et une valeur de référence prédéterminée étant au maximum de 10 %, de préférence au maximum de 5 %.
